# EUROPEAN PATENT APPLICATION

(11) **EP 4 811 936 A1**
(43) Date of publication of application: **23.09.2026**
(21) Application number: 24894012.4
(22) Date of filing: 07.11.2024
(51) Int. Cl.: H05K 1/18, H01L 23/12, H05K 3/28, H05K 3/34

(54) **CIRCUIT BOARD AND METHOD FOR MANUFACTURING MOUNTING BOARD**

(30) Priority: 21.11.2023 JP 2023197370
(71) Applicant: TDK Corporation, Tokyo 103-6128 (JP)
(72) Inventor: UEMATSU Hiroyuki, Tokyo 103-6128 (JP); WADA Yukari, Tokyo 103-6128 (JP); TANIGUCHI Susumu, Tokyo 103-6128 (JP)
(74) Representative: Epping - Hermann - Fischer
(86) International application number: PCT/JP2024/039676
(87) International publication number: WO 2025/110020

(57) **Abstract**

A circuit board includes a base material, at least a pair of terminals provided on the base material; a bonding material disposed on the terminals and containing a metal element; and an inner wall of an insulating material rising from the base material in a height direction orthogonal to a main surface of the base material. The pair of terminals and the bonding material are disposed in a cavity formed in the wall, at least one groove portion penetrating an outer peripheral surface from an inner peripheral surface is formed in the inner wall, and an outer wall of an insulating material rising from the base material in the height direction is provided on an outer peripheral side of the inner wall so as to surround the cavity.

## Description

### Technical Field

The present disclosure relates to a circuit board and a method for manufacturing a mounting board.

### Background Art

In recent years, digitalization has progressed, and along with this, the development of a technique for mounting electronic components on substrates is progressing. For example, a technique for mounting a large number of bare chips of semiconductor light emitting elements represented by light emitting diodes (hereinafter, referred to as "LEDs") used for lighting, display devices, and the like on a wiring board has been developed. For example, Patent Literature 1 discloses an invention in which semiconductor light emitting elements are inserted and bonded into a cavity in which a plurality of semiconductor light emitting elements can be easily positioned and arranged. Furthermore, in Patent Literature 2, a technique for suppressing carry-away of semiconductor light-emitting elements and solder bridging in electronic component mounting using a paste-like bonding material has also been developed.

### Citation List

### Patent Literature

Patent Literature 1: Japanese Unexamined Patent Publication No. 2006-93523
Patent Literature 2: Japanese Unexamined Patent Publication No. 2004-47772

### Summary of Invention

### Technical Problem

Here, in a circuit board, a terminal and a bonding material may be disposed inside a wall of an insulating material. With respect to such a circuit board, an electronic component may be mounted in such a manner that the inside of a wall is filled with a constituent material, the electronic component is installed using a holding member, and the electronic component may be bonded to the circuit board by pushing the electronic component into the wall using a pressurization reflow device and heating it. At this time, since the excessive constituent material stays in the wall and on the upper part of the wall around the electronic component, there is a possibility that the electronic component cannot be sufficiently pushed in a pressurizing step using a pressurization reflow device, and that a connection failure occurs between the bonding material for the circuit board and the electronic component. On the other hand, when the constituent material overflows and spreads on the base material, there is a problem that the surface of the base material is contaminated.

An object of the present disclosure is to provide a circuit board and a method for manufacturing a mounting board that are capable of suppressing a connection failure between a circuit board and an electronic component and suppressing contamination on a base material.

### Solution to Problem

A circuit board according to the present disclosure is a circuit board including: a base material; at least a pair of terminals provided on the base material; a bonding material disposed on the terminals and containing a metal element; and an inner wall of an insulating material rising from the base material in a height direction orthogonal to a main surface of the base material, in which the pair of terminals and the bonding material are disposed in a cavity formed in the inner wall, at least one groove portion penetrating an outer peripheral surface from an inner peripheral surface is formed in the inner wall, and an outer wall of an insulating material rising from the base material in the height direction is provided on the outer peripheral side of the inner wall so as to surround the cavity.

A method for manufacturing a mounting board according to the present disclosure is a method for manufacturing a mounting board by mounting an electronic component on the above-described circuit board to manufacture a mounting board, in which a constituent material is disposed on the base material, the electronic component is disposed, and then the electronic component may be bonded to the terminal by using a pressurization reflow device.

### Advantageous Effects of Invention

According to the present disclosure, it is possible to provide a circuit board and a method for manufacturing a mounting board capable of suppressing a connection failure between a circuit board and an electronic component and suppressing contamination on a base material.

### Brief Description of Drawings

FIG. 1 is a schematic cross-sectional view illustrating an example of a mounting board including a circuit board according to an embodiment of the present disclosure.
FIG. 2 is a schematic cross-sectional view illustrating an example of a circuit board according to an embodiment of the present disclosure.
FIG. 3 is a plan view of a circuit board.
FIGS. 4(a), 4(b), and 4(c) are diagrams illustrating a wall-frame portion of an inner wall as viewed in a thickness direction.
FIGS. 5(a) and 5(b) are cross-sectional views illustrating an example of a structure near a recessed portion.
FIG. 6 is a cross-sectional view of an example of an outer wall.
FIGS. 7(a), 7(b), and 7(c) are schematic diagrams illustrating an example of a method for manufacturing a circuit board and a mounting board.
FIG. 8 is a schematic diagram illustrating an example of a method for manufacturing a circuit board and a mounting board.
FIGS. 9(a), 9(b), 9(c), 9(d), 9(e), and 9(f) are schematic diagrams illustrating an example of a method for manufacturing a wall portion.
FIG. 10 is a schematic cross-sectional view illustrating a circuit board according to a comparative example.
FIG. 11 is a diagram illustrating a circuit board according to a modification.
FIG. 12 is a diagram illustrating a circuit board according to a modification.
FIG. 13 is a diagram illustrating a circuit board according to a modification.
FIGS. 14(a) and 14(b) are diagrams illustrating a circuit board according to a modification.
FIGS. 15(a), 15(b), and 15(c) are diagrams illustrating a circuit board according to a modification.
FIGS. 16(a), 16(b), and 16(c) are diagrams illustrating a circuit board according to a modification.
FIGS. 17(a), 17(b), 17(c), and 17(d) are diagrams illustrating a circuit board according to a modification.

### Description of Embodiments

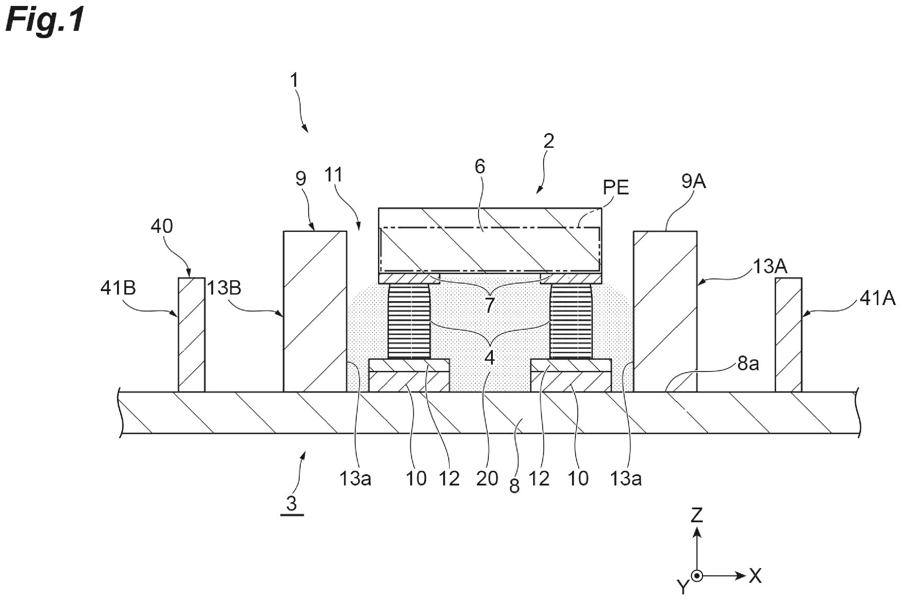

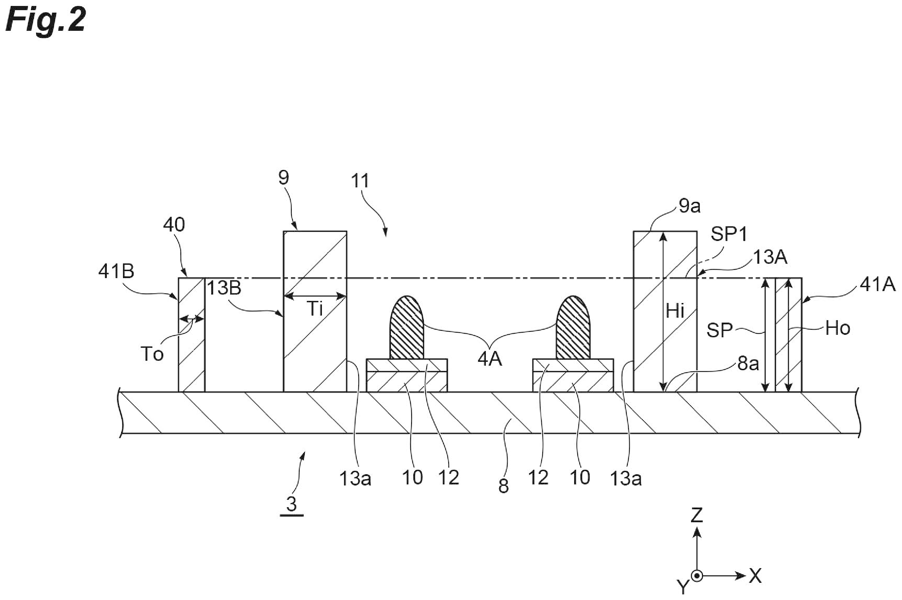

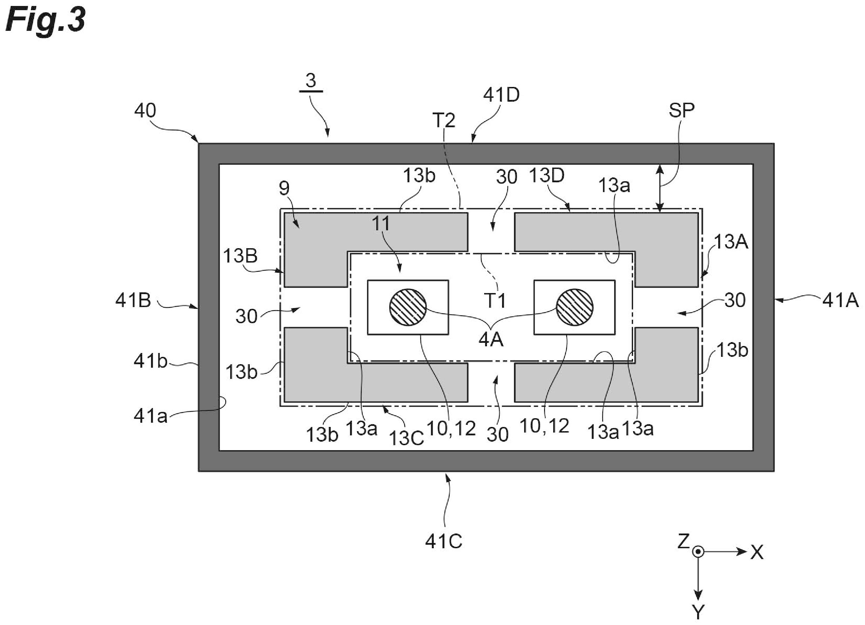

Referring to FIGS. 1 to 3, a circuit board 3 according to an embodiment of the present disclosure will be described. FIG. 1 is a schematic cross-sectional view illustrating a mounting board 1 including the circuit board 3 according to an embodiment of the present disclosure. FIG. 2 is a schematic cross-sectional view illustrating the circuit board 3 according to an embodiment of the present disclosure. FIG. 3 is a plan view of the circuit board 3.

As illustrated in FIG. 1, the mounting board 1 includes an electronic component 2 and the circuit board 3. The mounting board 1 is configured by mounting the electronic component 2 on the circuit board 3 via a bonding material 4.

The electronic component 2 includes a body portion 6 and a pair of terminals 7. The body portion 6 is a member for exhibiting a function as the electronic component 2. The terminals 7 are metal portions formed on a main surface of the body portion 6. As a material for the terminals 7, a metal such as Cu, Ti, Au, Ni, Sn, Bi, P, B, In, Ag, Zn, Pd, Mo, Pt, Cr, or an alloy selected from at least two of them, or the like is adopted. The electronic component 2 is configured of, for example, a micro LED, or the like. The micro LED is a component emitting light according to an input from the circuit board 3.

The circuit board 3 includes a base material 8, an inner wall 9, an outer wall 40, and a pair of terminals 10 (a first terminal and a second terminal). The base material 8 is a flat plate-shaped body portion of the circuit board 3. The base material 8 has a main surface 8a. As the base material 8, a printed board for mounting each conductor pattern and each electronic component on the main surface 8a in the circuit board 3 may be adopted. As a material for the base material 8, a known resin material or ceramic material used for a printed board may be adopted. Note that the following description may be made using XYZ coordinates set for the circuit board 3. An X-axis direction (second direction) is a direction parallel to the main surface 8a of the base material 8, a Y-axis direction (third direction) is a direction parallel to the main surface 8a of the base material 8 and orthogonal to the X-axis direction, and a Z-axis direction (first direction, height direction) is a direction orthogonal to the main surface 8a of the base material 8.

The inner wall 9 of an insulating material is provided on the main surface 8a of the base material 8. The inner wall 9 protrudes from the base material 8 toward the positive side in the Z-axis direction. As illustrated in FIG. 3, in the present embodiment, the inner wall 9 has wall-frame portions 13A, 13B, 13C, and 13D provided in four directions. The wall-frame portions 13A and 13B face each other in a state of being separated from each other in the X-axis direction, and extend in parallel to the Y-axis direction. The wall-frame portion 13A is disposed on the positive side in the X-axis direction, and the wall-frame portion 13B is disposed on the negative side. The wall-frame portions 13C and 13D face each other in a state of being separated from each other in the Y-axis direction, and extend in parallel to the X-axis direction. The wall-frame portion 13C is disposed on the positive side in the Y-axis direction, and the wall-frame portion 13D is disposed on the negative side. The wall-frame portion 13A connects end portions of the wall-frame portions 13C and 13D on the positive side in the X-axis direction to each other. The wall-frame portion 13B connects end portions of the wall-frame portions 13C and 13D on the negative side in the X-axis direction to each other. As a result, the inner wall 9 has a rectangular frame-shaped structure as viewed in the height direction. The wall-frame portions 13A and 13B constitute short sides, and the wall-frame portions 13C and 13D constitute long sides. Note that the dimension is not particularly limited, but the dimension in the Y-axis direction of the wall-frame portions 13A and 13B may be set to 10 µm to 60 µm. The dimension in the X-axis direction of the wall-frame portions 13C and 13D may be set to 15 µm to 70 µm. The dimension of the short side of the inner peripheral surface inside the inner wall 9 may be set to 8 µm or more and 44 µm or less. The dimension of the long side of the inner peripheral surface inside the inner wall 9 may be 15 µm or more and 68 µm or less. The dimension of the short side of the inner peripheral surface inside the inner wall 9 is the dimension between an inner peripheral surface 13a of the wall-frame portion 13C and an inner peripheral surface 13a of the wall-frame portion 13D in the Y-axis direction. The dimension of the long side of the inner peripheral surface inside the inner wall 9 is the dimension between an inner peripheral surface 13a of the wall-frame portion 13A and an inner peripheral surface 13a of the wall-frame portion 13B in the X-axis direction. As a material for the inner wall 9, for example, a resin material such as an epoxy resin, an acrylic resin, a phenol resin, a melamine resin, a urea resin, or an alkyd resin is adopted. Particularly preferably, as a material for the inner wall 9, an epoxy resin or an acrylic resin is adopted.

The outer wall 40 of an insulating material is provided on the main surface 8a of the base material 8. The inner wall 9 protrudes from the base material 8 toward the positive side in the Z-axis direction. The outer wall 40 is formed on the outer peripheral side of the inner wall 9 so as to surround a cavity 11. As illustrated in FIG. 3, in the present embodiment, the outer wall 40 has wall-frame portions 41A, 41B, 41C, and 41D provided in four directions. The wall-frame portions 41A and 41B face each other in a state of being separated from each other in the X-axis direction, and extend in parallel to the Y-axis direction. The wall-frame portion 41A is disposed on the positive side in the X-axis direction, and the wall-frame portion 41B is disposed on the negative side. The wall-frame portion 41A faces the wall-frame portion 13A of the inner wall 9 with a space therebetween on the positive side in the X-axis direction. The wall-frame portion 41B faces the wall-frame portion 13B of the inner wall 9 with a space therebetween on the negative side in the X-axis direction. The wall-frame portions 41C and 41D face each other in a state of being separated from each other in the Y-axis direction, and extend in parallel to the X-axis direction. The wall-frame portion 41C is disposed on the positive side in the Y-axis direction, and the wall-frame portion 41D is disposed on the negative side. The wall-frame portion 41C faces the wall-frame portion 13C of the inner wall 9 with a space therebetween on the positive side in the Y-axis direction. The wall-frame portion 41D faces the wall-frame portion 13D of the inner wall 9 with a space therebetween on the negative side in the Y-axis direction. The wall-frame portion 41A connects end portions of the wall-frame portions 41C and 41D on the positive side in the X-axis direction to each other. The wall-frame portion 41B connects end portions of the wall-frame portions 41C and 41D on the negative side in the X-axis direction to each other. As a result, the outer wall 40 has a rectangular frame-shaped structure as viewed in the height direction. The wall-frame portions 41A and 41B constitute short sides, and the wall-frame portions 41C and 41D constitute long sides. The dimension of the outer wall 40 in the XY plane is not particularly limited, but may be any size as long as the size satisfies a volume relationship described later with the inner wall 9 and the like. As the material for the outer wall 40, the same one as that described for the inner wall 9 may be adopted. However, depending on the manufacturing process, different materials may be used for the outer wall 40 and the inner wall 9.

As illustrated in FIGS. 1 to 3, the terminals 10 are metal portions provided on the main surface 8a of the base material 8. As a material for the terminals 10, Ni, Cu, Ti, Cr, Al, Mo, Pt, Au, an alloy selected from at least two of them, or the like is adopted. A conductive film 12 is formed on an upper surface of the terminal 10. As a material for the conductive film 12, a film of Ti, Cu, Ni, Al, Mo, Cr, Ag, or the like, a film in which metal particles and a binder are mixed, or the like is adopted.

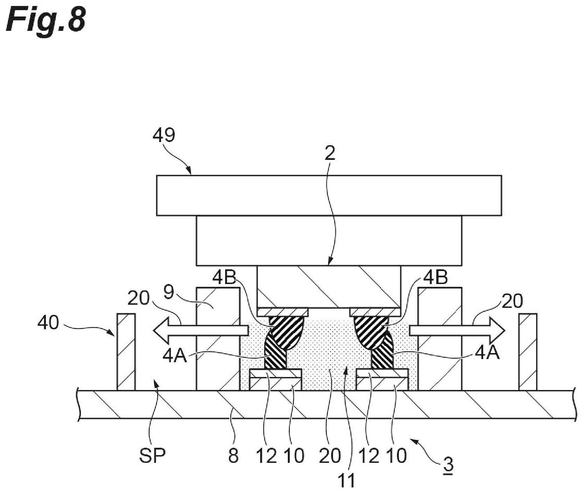

The bonding material 4 is a member bonding the terminals 7 of the electronic component 2 and the terminals 10 of the circuit board 3. The bonding material 4 is configured by thermally bonding and integrating a bonding material 4A on the circuit board 3 side and a bonding material 4B on the electronic component 2 side (see FIG. 8). The bonding material 4 may contain Sn or may be made of an alloy containing Sn. However, the bonding material 4 is not necessarily limited to one containing Sn. The bonding material 4 may be made of an alloy containing, in addition to Sn, an element lowering a melting point of Sn. Examples of the element lowering a melting point of Sn include Bi. The bonding material 4 functions as solder. Thus, the terminal 10, the conductive film 12, the bonding material 4, and the terminal 7 are stacked in this order from the upper surface of the base material 8 between the base material 8 and the body portion 6. Note that solder bonding is performed at that location after the terminal 10, the conductive film 12, the bonding material 4, and the terminal 7 are stacked. Therefore, after the solder bonding, a structure in which the metals of the terminal 10, the conductive film 12, the bonding material 4, and the terminal 7 are melted and diffused is formed. The structure after such solder bonding may be a structure containing a brittle intermetallic compound (IMC). When an intermetallic compound having a brittle structure is present, it is likely to be fractured due to stress from the outside, and thus reliability tends to decrease. Therefore, the effect of protecting the electronic component 2 is achieved by surrounding the electronic component 2 with the inner wall 9.

The cavity 11 is formed in the inner wall 9. The cavity 11 is formed of a through hole penetrating the inner wall 9 in the height direction. Thus, the upper surface of the base material 8 is exposed on the bottom side of the cavity 11. The cavity 11 has a rectangular shape as viewed in the height direction (see FIG. 3). The terminals 7, the terminals 10, the conductive films 12, and the bonding material 4 are disposed in the cavity 11 surrounded by the inner wall 9 so as to be surrounded by the inner wall 9. Slight gaps are formed between the inner peripheral surfaces 13a of the four wall-frame portions 13A, 13B, 13C, and 13D constituting the cavity 11, and the terminals 7, the terminals 10, the conductive films 12, and the bonding material 4.

A constituent material 20 is disposed between the electronic component 2 and the bonding material 4, and the inner wall 9 in the cavity 11. Thus, the electronic component 2 can be made difficult to be separated from the circuit board 3 by being supported by the constituent material 20. Furthermore, a force applied to the electronic component 2, the bonding material 4, and the terminals 7 and 10 is relaxed, and reliability can be improved. As a material for the constituent material 20, for example, an epoxy resin, an acrylic resin, a phenol resin, a melamine resin, a urea resin, an alkyd resin, a mixture thereof, or a mixture of the above-described resin materials with SiOx, ceramics, and the like is adopted. Particularly preferably, as a material for the constituent material 20, an epoxy resin or an acrylic resin is adopted. A viscosity of the constituent material 20 at the time of filling may be 1 Pa to 20 Pa, and more preferably, 5 Pa to 10 Pa.

As illustrated in FIG. 2, the circuit board 3 has a configuration in which the electronic component 2 and the constituent material 20 are removed from the mounting board 1 illustrated in FIG. 1. Note that in the circuit board 3, the bonding material 4A containing a metal element is disposed above the terminal 10 (on the upper surface of the conductive film 12). The circuit board 3 includes the bonding material 4A (first bonding material) disposed on the terminal 10 on the side in the X-axis direction and the bonding material 4A (second bonding material) disposed on the terminal 10 on the negative side in the X-axis direction. As described above, these bonding materials 4A constitute a part of the bonding material 4 in a stage before the electronic component 2 and the mounting board 1 are thermally bonded. In the state of the circuit board 3, the pair of terminals 10, the conductive films 12, and the bonding materials 4A are disposed inside the inner wall 9 formed of an insulating material.

As illustrated in FIG. 3, the wall-frame portions 13A, 13B, 13C, and 13D have at least one groove portion 30 penetrating from the inner peripheral surface 13a to the outer peripheral surface 13b. Note that for the wall-frame portions 13A and 13B, the X-axis direction is the thickness direction. Therefore, the groove portions 30 of the wall-frame portions 13A and 13B extend in the X-axis direction and penetrate the wall-frame portions 13A and 13B. For the wall-frame portions 13C and 13D, the Y-axis direction is the thickness direction. Therefore, the groove portions 30 of the wall-frame portions 13C and 13D extend in the Y-axis direction and penetrate the wall-frame portions 13C and 13D. Note that the groove portion 30 may be formed in at least one of the wall-frame portions 13A, 13B, 13C, and 13D. Furthermore, a plurality of groove portions 30 may be formed in any one of the wall-frame portions 13A, 13B, 13C, and 13D. Furthermore, the groove portion 30 may be formed at a corner portion of each of the wall-frame portions 13A, 13B, 13C, and 13D (details will be described later).

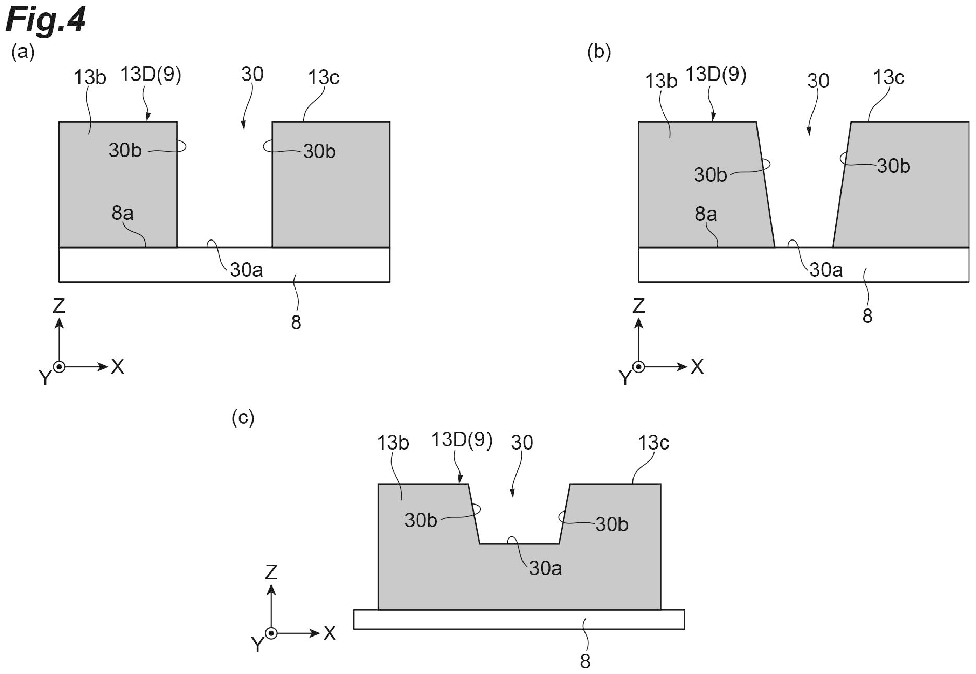

Next, referring to FIGS. 4(a), 4(b), and 4(c), a configuration of the wall-frame portion 13D as viewed in the thickness direction will be described. FIG. 4(a) is diagram illustrating the wall-frame portion 13D as viewed in the Y-axis direction that is the thickness direction. Note that although the wall-frame portion 13D is illustrated in FIGS. 4(a), 4(b), and 4(c), the same description holds for the other wall-frame portions 13A, 13B, and 13C. As illustrated in FIG. 4(a), as viewed in the Y-axis direction that is the thickness direction of the wall-frame portion 13D, the groove portion 30 extends from a distal end portion 13c in the height direction (the Z-axis direction in the present embodiment) of the wall-frame portion 13D toward the base material 8 side (the negative side in the Z-axis direction). The groove portion 30 has a bottom surface 30a and a pair of side surfaces 30b. The bottom surface 30a is formed on the negative side in the Z-axis direction with respect to the distal end portion 13c. The pair of side surfaces 30b extends from both end portions of the bottom surface 30a in the X-axis direction to the distal end portion 13c. In an example illustrated in FIG. 4(a), the groove portion 30 extends to the main surface 8a of the base material 8. In this case, the main surface 8a of the base material 8 forms the bottom surface 30a of the groove portion 30. In this configuration, a region on the negative side in the X-axis direction and a region on the positive side in the X-axis direction of the wall-frame portion 13D are divided by the groove portion 30.

As illustrated in FIG. 4(b), the width of the groove portion 30 in the X-axis direction, which is the width direction, is larger on the distal end portion 13c side than on the bottom surface 30a side. The width of the groove portion 30 at the distal end portion 13c is larger than the width of the groove portion 30 at the bottom surface 30a. In the example illustrated in FIG. 4(b), the groove portion 30 is largely opened in the X-axis direction toward the distal end portion 13c side. The pair of side surfaces 30b is inclined such that the distance between the side surfaces increases toward the positive side in the Z-axis direction.

As illustrated in FIG. 4(c), the bottom surface 30a of the groove portion 30 may be disposed at a position separated from the base material 8. The member of the wall-frame portion 13D exists between the bottom surface 30a and the main surface 8a of the base material 8. The height dimension of the groove portion 30 when the bottom surface 30a is separated from the base material 8 is not particularly limited, and may be 1 µm or more.

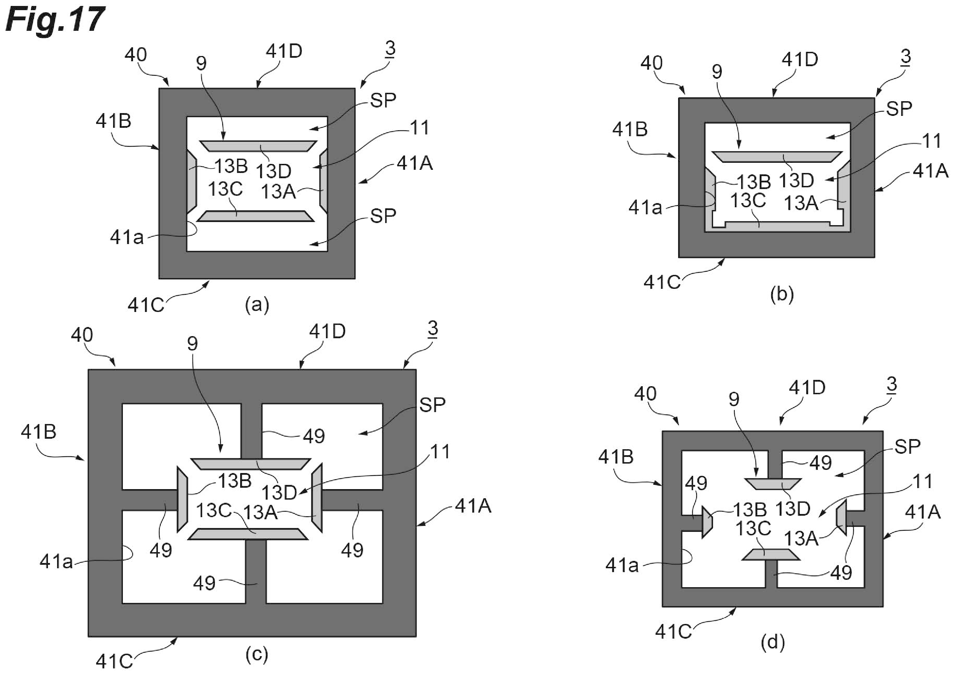

Note that the width of the groove portion 30 is not particularly limited as long as it is a dimension that is not excessively small in order to discharge the excessive constituent material 20. For example, the width of the groove portion 30 may be 1 µ or more, and may be 4 µm or more. Note that the wall-frame portion 13 only needs to be large enough to position the electronic component 2, and the width of the groove portion 30 may be set to be large (for example, see FIG. 17(d)). Even in this case, it is possible to hold the necessary constituent material 20 and discharge the excessive material. When the bottom surface 30a is disposed at a position separated from the base material 8, the bottom surface 30a may have a curved shape.

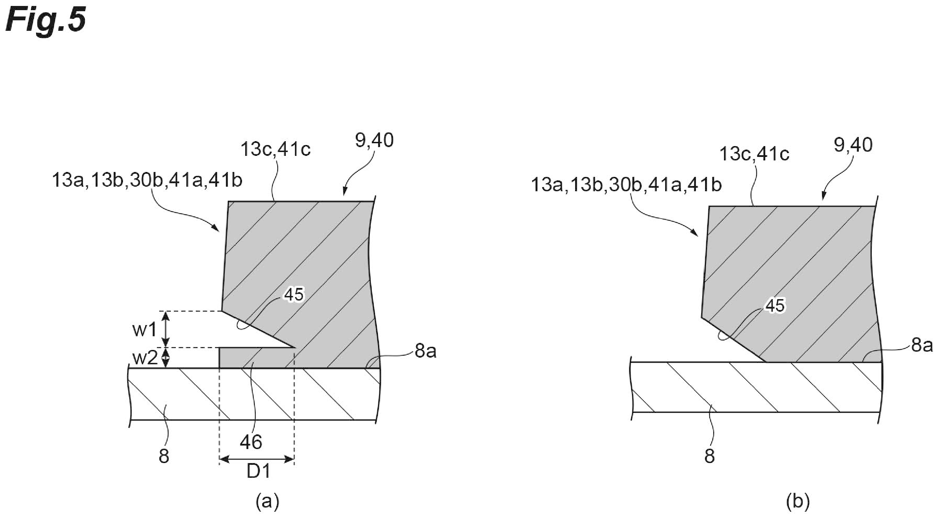

The relationship between the sizes of the inner wall 9 and the outer wall 40 will be described. As illustrated in FIG. 2, the relationship between the thickness Ti of the inner wall 9 and the thickness To of the outer wall 40 is not particularly limited. As will be described later, in the case of the outer wall 40 formed in a pattern (deposited approximately uniformly) formed of a continuous insulating material covering the main surface 8a of the base material 8, the thickness To is very large. In the case of the frame-shaped outer wall 40 as illustrated in FIGS. 1 to 3, the thickness Ti of the inner wall 9 may be equal to or greater than the thickness To of the outer wall 40. The thicknesses Ti and To are dimensions of the wall-frame portions 13A, 13B, 41A, and 41B in the X-axis direction. The thicknesses Ti and To are dimensions of the wall-frame portions 13C, 13D, 41C, and 41D in the Y-axis direction. Although not particularly limited, the thickness Ti of the inner wall 9 may be set to 1 µm or more and to the height Hi of the inner wall 9 or less. The thickness To of the outer wall 40 may be set to 1 µm or more and to the height Ho of the outer wall 40 or less. As will be described later, the cross-sectional shapes of the wall-frame portions 13A, 13B, 13C, 13D, 41A, 41B, 41C, and 41D may not be constant in the height direction (for example, see FIG. 5(a)), and when the thicknesses Ti and To are compared with each other, the thicknesses at the bottom portions, that is, at the positions on the base material 8, may be compared.

The height Hi of the inner wall 9 may be equal to or greater than the height Ho of the outer wall 40. The heights Hi and Ho are dimensions in the height direction of the wall-frame portions 13A, 13B, 13C, 13D, 41A, 41B, 41C, and 41D. Although not particularly limited, the height Hi of the inner wall 9 may be set to 4 µm or more and 10 µm or less. The height Ho of the outer wall 40 may be set to 1 µm or more and to the height Hi of the inner wall 9 or less. When the heights of the distal end portions 13c and 41c of the respective walls are not uniform, the heights Hi and Ho are defined by the maximum heights.

As illustrated in FIG. 3, a rectangular reference shape T1 having a minimum area circumscribing the inner peripheral surface 13a of the cavity 11 of the inner wall 9, when viewed from the height direction, is set. A rectangular reference shape T2 having a maximum area inscribed in the outer peripheral surface 13b of the inner wall 9, when viewed from the height direction, is set. In the present embodiment, the reference shapes T1 and T2 are rectangular. These reference shapes T1 and T2 are virtually set, and are indicated by virtual lines in FIG. 3. A volume obtained by multiplying the height Hi (see FIG. 2) of the inner wall 9 by the reference shape T1 is defined as S1 that is a volume in the cavity 11.

A rectangular annular space SP is formed between the inner wall 9 and the inner peripheral surface 41a of the outer wall 40. The constituent material 20 discharged from the cavity 11 is accommodated in the space SP. The area of the space SP when viewed from the height direction is the area of a region between the rectangle drawn by the inner peripheral surface 41a of the outer wall 40 and the reference shape T2 on the outer peripheral side of the inner wall 9. The height of the space SP is the lower height of the inner wall 9 and the outer wall 40. In the example illustrated in FIG. 2, the relationship between the heights of the inner wall 9 and the outer wall 40 is "Hi ≥ Ho". A region lower than a reference position SP1 indicating the height Ho of the outer wall 40 is the space SP. Therefore, the volume of the space SP obtained by multiplying the area by the height Ho of the outer wall 40 is defined as S2.

As illustrated in FIG. 1, the electronic component 2 is mounted in the cavity 11. The electronic component 2 is a member that pushes out the constituent material 20 filling the cavity 11 before joining. The maximum volume of the extruded constituent material 20 may be regarded as the volume occupied by the electronic component 2 in the cavity 11 after joining. In the electronic component 2, a volume of a portion that enters the cavity 11, that is, a region (referred to as PE) disposed at a position lower than the distal end portion 9a of the inner wall 9, is defined as a volume occupied by the electronic component 2 in the cavity 11, and such a volume is defined as S3.

As described above, it is defined that the volume in the cavity 11 is S1, the volume of the space SP between the inner wall 9 and the outer wall 40 is S2, and the volume occupied by the electronic component mounted in the cavity 11 is S3. At this time, S2 may be S1 or less (S2 ≤ S1). In addition, S2 may be S3 or more (S2 ≥ S3).

Here, as shown in FIG. 5(a), one of the surfaces extending in the height direction of at least one of the inner wall 9 and the outer wall 40 has a recessed portion 45 at a position on the base material 8 side in the height direction. A cavity material 46 covering the base material 8 may be provided at the position of the recessed portion 45. The surfaces extending in the height direction in the inner wall 9 are the inner peripheral surface 13a, the outer peripheral surface 13b, and the side surfaces 30b of the groove portion 30. The surfaces extending in the height direction in the outer wall 40 are the inner peripheral surface 41a and the outer peripheral surface 41b. It is sufficient that any of these surfaces 13a, 13b, 30b, 41a, and 41b have the recessed portion 45. Further, the recessed portion 45 may not be provided in the entire region of each of the surfaces 13a, 13b, 30b, 41a, and 41b, and may be provided in a part thereof. The recessed portion 45 is formed at a position closer to the base material 8 than the distal end portions 13c and 41c in the height direction. The recessed portion 45 is formed at a position spaced upward from the main surface 8a of the base material 8. Therefore, the cavity material 46 is formed between the recessed portion 45 and the main surface 8a of the base material 8. The recessed portion 45 may extend in a direction in which the surfaces 13a, 13b, 30b, 41a, and 41b extend along the planar direction of the base material 8. For example, when the inner peripheral surface 13a of the wall-frame portion 13A has the recessed portion 45, the recessed portion 45 may be formed so as to extend in the Y-axis direction. When the side surface 30b of the groove portion 30 of the wall-frame portion 13A has the recessed portion 45, the recessed portion 45 may be formed so as to extend in the X-axis direction.

The opening width of the recessed portion 45, that is, the size of a dimension w1 of the opening in the height direction is not particularly limited, but may be set to 0 µm or more and 3 µm or less. The thickness of the cavity material 46, that is, the size of a dimension w2 in the height direction, is not particularly limited, but may be set to 0 µm or more and 1 µm or less. A dimension D1 of the depth of the recessed portion 45 is not particularly limited, but may be set to 0 µm or more and 3 µm or less. In the example shown in FIG. 5(b), the recessed portion 45 is formed at a position directly above the base material 8, and the cavity material 46 is not formed. In such a structure, the bonding strength between the walls 9 and 40 and the base material 8 decreases, and thus the structure of FIG. 5(a) is preferable. However, the structure illustrated in FIG. 5(b) is not excluded.

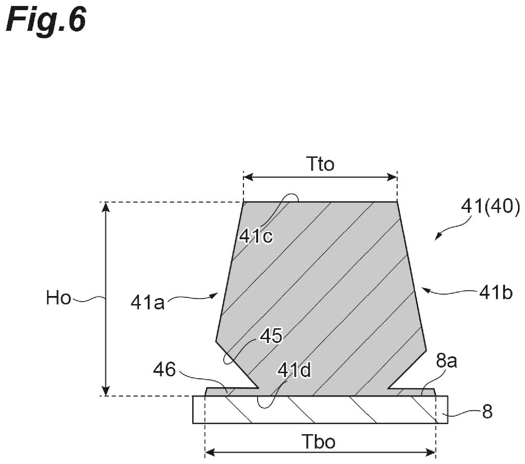

The cross-sectional shape of the frame-shaped outer wall 40 will be described with reference to FIG. 6. The thickness of the outer wall 40 at a distal end portion 41c in the height direction of the wall-frame portion 41 is denoted by Tto, the thickness of an end portion 41d on the base material 8 side is denoted by Tbo, and the height of the wall-frame portion of the outer wall is denoted by Ho. When an end portion 41d on the base material 8 side has a tapered shape thicker than the distal end portion 41c as shown in FIG. 6, a condition of a tapered shape in which Tbo is equal to or greater than Tto and equal to or greater than Ho is satisfied. In the case of the shape as shown in FIG. 5 (b), the distal end portion 41c may be thicker than the end portion 41d on the base material 8 side. In this case, a condition of a tapered shape in which Tto is equal to or greater than Tbo and equal to or greater than Ho may be satisfied.

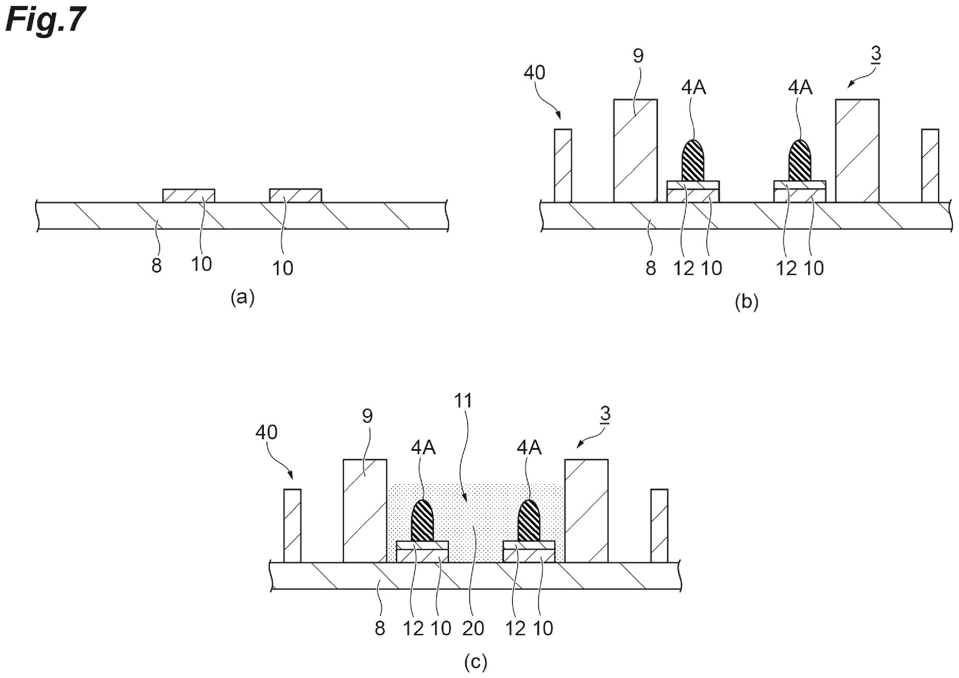

Referring to FIGS. 7(a), 7(b), 7(c) and FIG. 8, a method for manufacturing the circuit board 3 and the mounting board 1 will be described. First, as illustrated in FIG. 7(a), the terminals 10 are formed on the upper surface of the base material 8. Next, as illustrated in FIG. 7(b), the inner wall 9 and the outer wall 40 are formed on the base material 8. Thus, the circuit board 3 is completed. In FIG. 7(b), the conductive film 12 and the bonding material 4A are formed on the upper surface of the terminal 10. Next, as illustrated in FIG. 7(c), the constituent material 20 is disposed on the base material 8 by filling the cavity 11 with the constituent material 20. Then, the electronic component 2 is held by a holding member, and the electronic component 2 is installed in the cavity 11. Next, as illustrated in FIG. 8, the electronic component 2 is pushed into the cavity 11 by a pressurization reflow device 49 with respect to the electronic component 2, and the bonding material 4A and the bonding material 4B are brought into contact with each other inside the constituent material 20. At this time, a part of the constituent material 20 is pushed out to the groove portion 30 (see FIG. 3). At this time, the extruded constituent material 20 is received in the space SP between the outer wall 40 and the inner wall 9. Then, the bonding material 4B of the electronic component 2 and the bonding material 4A of the base material 8 are bonded by heating. Thus, the mounting board 1 is completed.

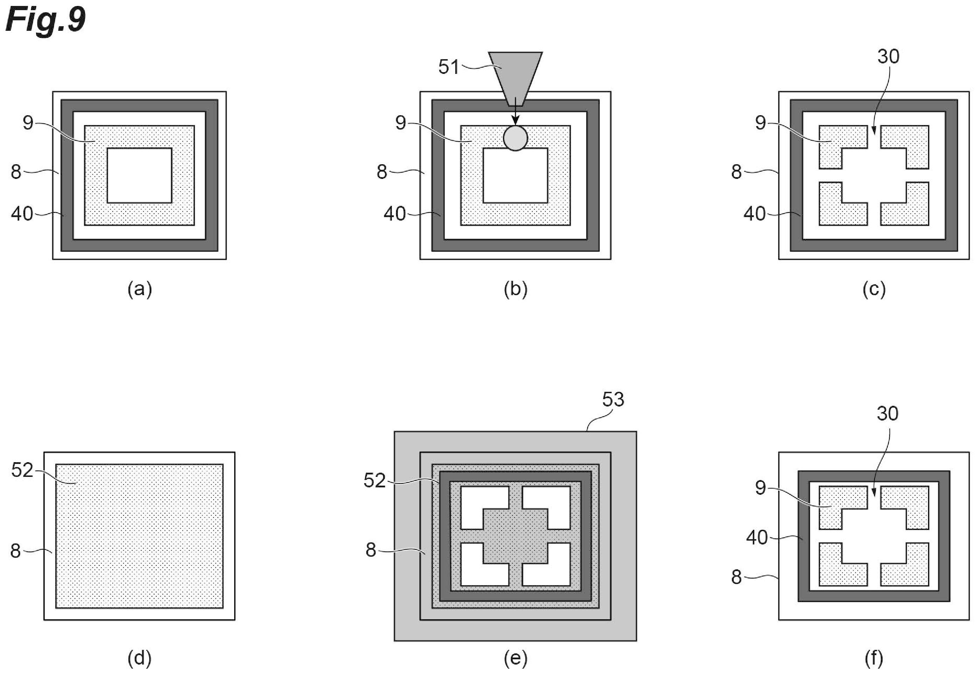

Next, a method for forming the inner wall 9 and the outer wall 40 having the groove portion 30 will be described with reference to FIGS. 9(a), 9(b), 9(c), 9(d), 9(e), and 9(f). First, as illustrated in FIG. 9(a), the inner wall 9 and the outer wall 40 are formed on the base material 8. Next, as illustrated in FIG. 9(b), a part of the inner wall 9 is processed by irradiating the inner wall 9 with a laser beam by a laser device 51. As a result, as illustrated in FIG. 9(c), the groove portion 30 is formed in the inner wall 9.

Alternatively, as illustrated in FIG. 9(d), a resist 52 is formed on the base material 8. Then, as illustrated in FIG. 9(e), exposure is performed using a glass mask 53 having a pattern corresponding to the shape of the inner wall 9 having the groove portion 30 and the shape of the outer wall 40. As illustrated in FIG. 9(f), the exposed resist 52 is developed to form the inner wall 9 having the groove portion 30 and the outer wall 40.

Next, functions and effects of the circuit board 3 and the method for manufacturing the mounting board 1 according to the present embodiment will be described.

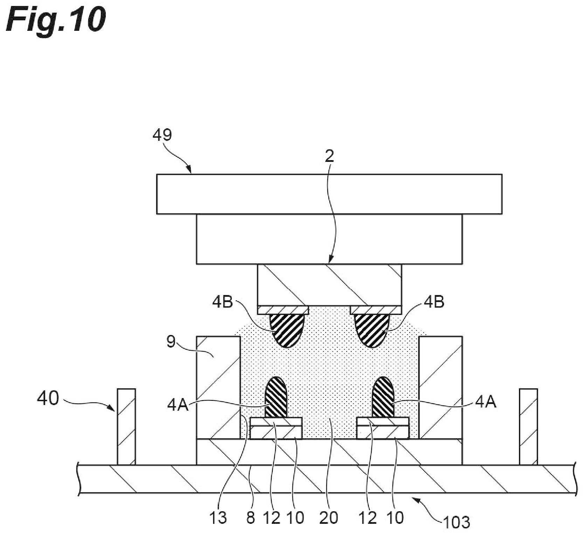

First, a circuit board 103 according to a comparative example will be described with reference to FIG. 10. The inner wall 9 of the circuit board 103 does not have the groove portion 30 and the outer wall 40 described above. After the inside of the inner wall 9 is filled with the constituent material 20, when the electronic component 2 is installed in the inner wall 9 using a holding member and the electronic component 2 is pushed by a pressurization reflow device, the electronic component 2 cannot be sufficiently pushed in due to the influence of the excessive constituent material 20. In this case, reflow is performed in a state where the bonding material 4B of the electronic component 2 and the bonding material 4A of the circuit board 3 remain separated from each other, and there is a possibility that a connection failure occurs between the bonding material 4A of the circuit board 3 and the electronic component 2.

On the other hand, in the circuit board 3 according to the present embodiment, the pair of terminals 10 (first terminal and second terminal) are disposed in the cavity 11 surrounded by the inner wall 9. Here, the inner wall 9 has at least one groove portion 30 penetrates the outer peripheral surface 13b from the inner peripheral surface 13a. In this case, when the electronic component 2 is mounted on the circuit board 3 by disposing the constituent material 20 in the cavity 11, installing the electronic component using a holding member, and pushing the electronic component 2 into the cavity 11 using the pressurization reflow device and heating it to bond the electronic component 2 to the circuit board 3, the excessive constituent material 20 can be discharged to the outside of the inner wall 9 through the groove portion 30. As a result, the electronic component 2 can be sufficiently pushed into the cavity 11 in a pressurizing step using the pressurization reflow device and brought into contact with the bonding material 4. Furthermore, on the outer peripheral side of the inner wall 9, the outer wall 40 of an insulating material rising in the Z-axis direction (first direction) from the base material 8 is provided so as to surround the cavity 11. Therefore, since the outer wall 40 can block the excessive constituent material 20 discharged through the groove portion 30, it is possible to suppress the constituent material 20 from spreading to the main surface 8a of the base material 8. As described above, a connection failure between the bonding material 4 of the circuit board 3 and the electronic component 2 can be suppressed and contamination on the base material can also be suppressed.

The circuit board 3 may include the bonding material 4A (first bonding material) containing a metal element and disposed on the terminal 10A and the bonding material 4A (second bonding material) containing a metal element and disposed on the terminal 10B. In this case, the electronic component 2 can be mounted on the terminals 10A and 10B via the bonding materials 4A.

The height Hi of the inner wall 9 may be equal to or greater than the height Ho of the outer wall 40. In this case, by increasing the height of the inner wall 9, the electronic component 2 can be easily pressurized against the cavity 11 of the inner wall 9.

When it is defined that the volume of the space between the inner wall 9 and the outer wall 40 is S2, and the volume occupied by the electronic component mounted in the cavity 11 is S3, S2 may be equal to or greater than S3. In this case, the space SP between the outer wall 40 and the inner wall 9 can ensure a volume necessary to receive the constituent material 20 discharged from the cavity 11.

On any surface of at least one of the inner wall 9 and the outer wall 40 extending in the Z-axis direction, the recessed portion 45 is formed at a position on the base material 8 side in the Z-axis direction, and a cavity material 46 covering the base material 8 may be provided at the position of the recessed portion 45. According to such a shape, the recessed portion 45 can function as a guide groove through which the constituent material 20 passes at a position on the base material 8 side. Therefore, the fluidity of the constituent material 20 can be improved.

Assuming that Tto represents the thickness of the wall-frame portion 41 of the outer wall 40 at the distal end portion 41c in the Z axis direction, that Tbo represents the thickness of the end portion 41d on the base material side, and that Ho represents the height of the wall-frame portion 41 of the outer wall 40, a condition of a tapered shape in which Tbo is equal to or larger than Tto and equal to or larger than Ho may be satisfied. This configuration may be adopted when the outer wall 40 is formed in a frame shape.

The groove portion 30 may extend from the distal end portion of the wall-frame portion 13 in the Z-axis direction toward the base material 8 side as viewed in the thickness direction of the wall-frame portion 13 of the inner wall 9, and the width of the groove portion 30 in the width direction orthogonal to the thickness direction and the Z-axis direction may be larger on the distal end portion 13c side than on the bottom surface 30a side. In this case, the channel resistance increases by narrowing the groove portion 30 on the base material 8 side, and the necessary constituent material is held, and the excessive constituent material is easily discharged by widening the groove portion 30 on the distal end portion side.

The method for manufacturing the mounting board 1 according to the present embodiment is a method for manufacturing the mounting board 1 by mounting the electronic component 2 on the above-described circuit board 3 to manufacture the mounting board 1, in which the constituent material 20 is disposed on the base material 8, and after the electronic component 2 is disposed, the electronic component 2 may be bonded to the terminal 10 by using the pressurization reflow device 49.

In this case, the same functions and effects as those of the above-described circuit board 3 can be obtained.

The present disclosure is not limited to the embodiment described above. For example, the number and arrangement of terminals of the circuit board are not particularly limited. Furthermore, although one electronic component 2 is disposed in the inner wall 9 in the above-described embodiment, a plurality of electronic components 2 may be disposed. An arrangement mode of the plurality of electronic components 2 is not particularly limited.

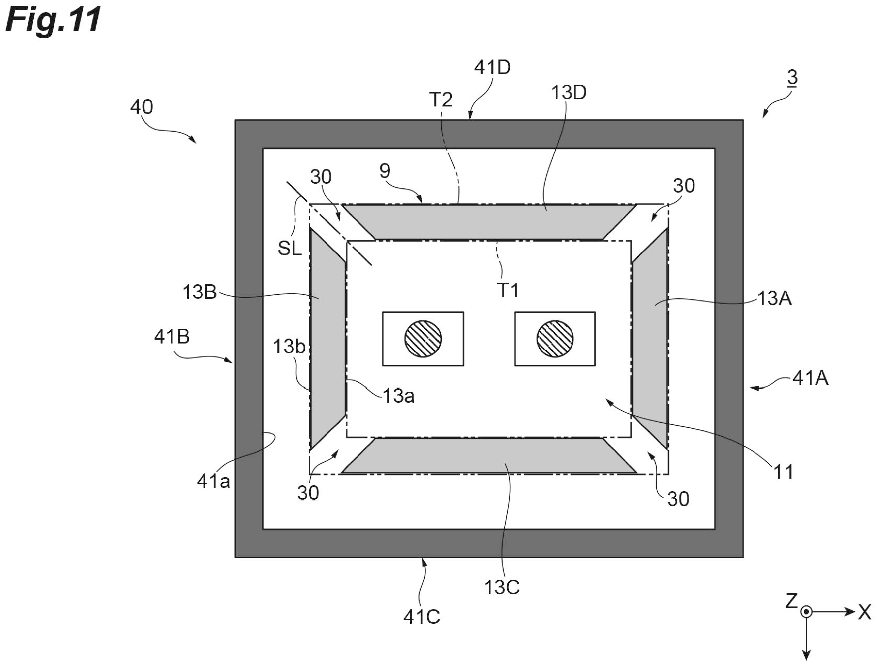

In the above-described embodiment, the groove portion 30 is formed in each of the wall-frame portions 13A, 13B, 13C, and 13D. Alternatively or additionally, the groove portion 30 may be formed at a corner portion of the inner wall 9. For example, a configuration illustrated in FIG. 11 may be employed. In the example shown in FIG. 11, the groove portions 30 are formed at four corner portions of the inner wall 9 in a rectangular shape. A line connecting corners of the virtual reference shapes T1 and T2 set for the inner wall 9 is defined as a reference line SL. At this time, the groove portion 30 may extend along the direction in which the reference line SL extends. As a result, the groove portion 30 penetrates the inner wall 9 at the position of the corner of the reference shape T1 on the inner peripheral side and the position of the corner of the reference shape T2 on the outer peripheral side. Note that the recessed portion 45 as illustrated in FIGS. 5(a) and 5(b) may also be formed in the groove portion 30 formed at the corner portion.

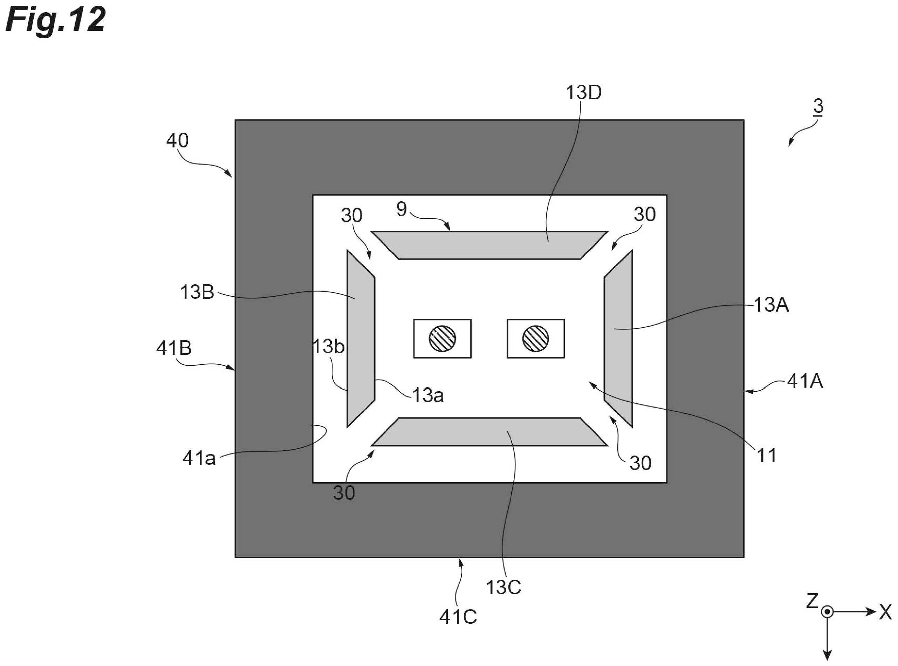

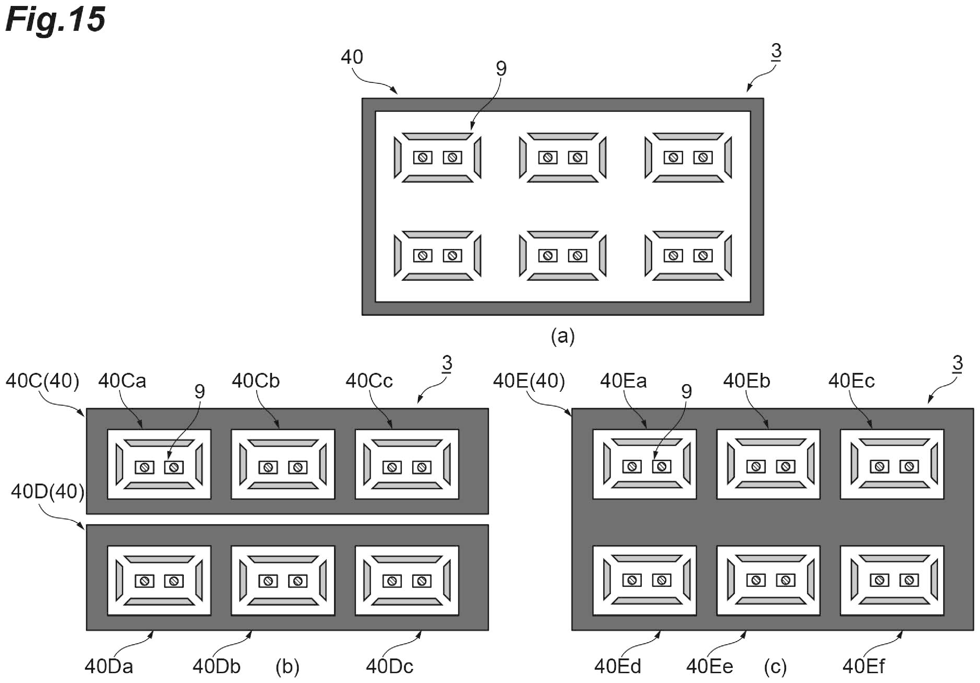

The structure of the outer wall 40 is not particularly limited, and the structure illustrated in FIG. 12 may be adopted. In the example illustrated in FIG. 12, instead of the outer wall 40 having the frame shape, the outer wall has a pattern formed of a continuous insulating material (deposited approximately uniformly) covering the main surface 8a of the base material 8. The pattern is a pattern formed by applying an insulating material so as to continuously cover the main surface 8a of the base material 8. In the following description, such a pattern may be referred to as a continuous pattern, and a film formed with such a pattern may be referred to as a continuous film. The outer wall 40 of the continuous pattern extends, for example, as illustrated in FIG 15(c), to the outer wall 40 for the adjacent cavity 11 and has an integrated shape. That is, there is no break in the outer wall 40 between the cavity 11 and the adjacent cavity 11. When not only the periphery of the cavity 11 but also the surface of the base material 8 is covered over a wide range, the surface of the base material 8 can be protected by the outer wall 40. When the region between the cavity 11 and the cavity 11 is covered with the outer wall 40 without a gap, the surface of the base material 8 in the region can be protected with the outer wall 40. The vicinity of the edge of the base material 8 may or may not be covered with the outer wall 40.

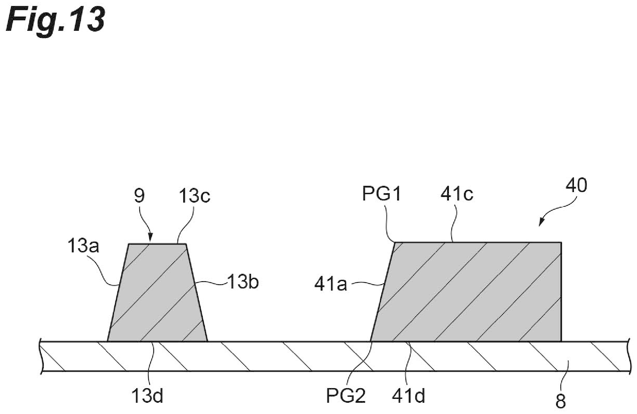

Here, in the case where the outer wall 40 is formed of a continuous film or the like, that is, a wide film, as illustrated in FIG. 13, an end portion 41d on the base material 8 side in the height direction of the inner peripheral surface 41a of the outer wall 40 may be disposed on the inner peripheral side of the distal end portion 41c. In FIG. 13, a position PG2 of the end portion 41d on the base material 8 side in the inner peripheral surface 41a is disposed on the inner peripheral side of a position PG1 of the distal end portion 41c. At this time, on the outer peripheral surface 13b of the inner wall 9, an end portion 13d on the base material 8 side is disposed on the outer peripheral side of the distal end portion 13c.

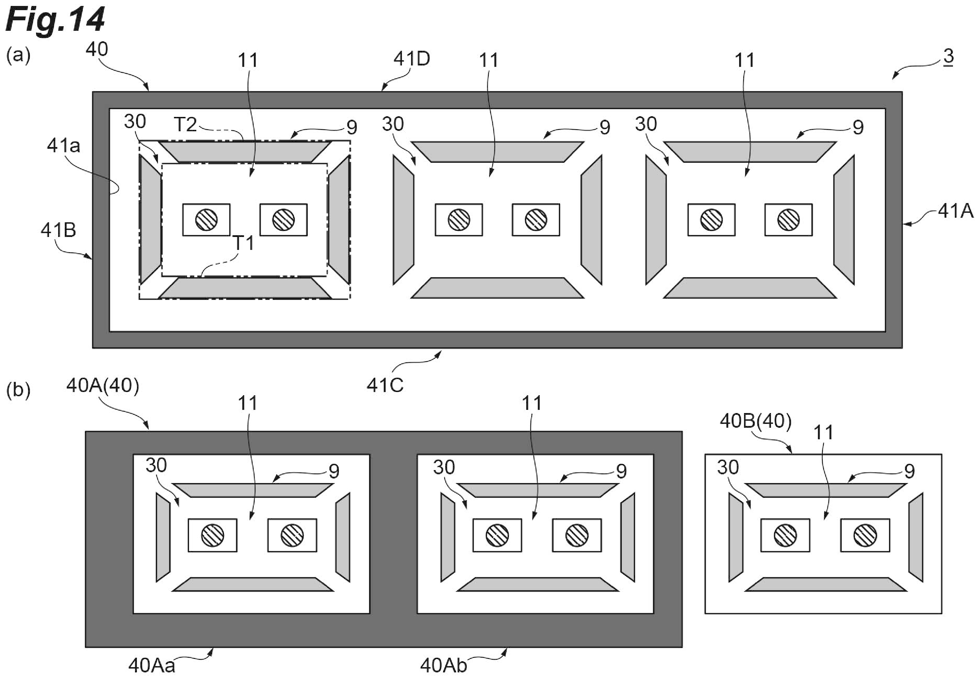

As illustrated in FIGS. 14(a) and 14(b) and FIGS. 15(a), 15(b), and 15(c), various variations may be adopted as the structure of the outer wall 40. As illustrated in FIG. 14(a), a plurality of inner walls 9 may be provided inside the outer wall 40. That is, the outer wall 40 may collectively surround the cavities 11 of the plurality of inner walls 9. Specifically, a plurality of (three) inner walls 9 are arranged in parallel between the wall-frame portion 41C and the wall-frame portion 41D. The wall-frame portion 41A and the wall-frame portion 41B collectively sandwich the plurality of inner walls 9 arranged in series in the opposing direction.

In FIG. 14(a), when viewed from the height direction, the area of the cavity 11 in one inner wall 9 is denoted by SA1, and the total area between a plurality of n inner walls 9 and the outer wall 40 is denoted by SA2. The area SA1 is an area of the reference shape T1 on the inner peripheral side with respect to the inner wall 9. SA2 is a value obtained by subtracting the sum of the areas of n reference shapes T2 on the outer peripheral side of the inner wall 9 from the area of the rectangle formed by the inner peripheral surface 41a of the outer wall 40. In FIG. 14(a), since three inner walls 9 are provided, "n = 3" is established. At this time, the following Formulas (1) and (2) may be established. In this case, the outer wall 40 can collectively receive the constituent materials 20 discharged from the plurality of inner walls 9. In addition, the space between the outer wall 40 and the plurality of inner walls 9 can ensure a volume necessary for receiving the discharged constituent material 20. $SA 2 \geq \left(n\times SA1\right) / 3$ $SA 2 \leq n \times SA 1$

As illustrated in FIG. 14(b), an outer wall 40B formed of a continuous film and a frame-shaped outer wall 40A may be combined. In FIG. 14(b), two inner walls 9 are surrounded by the outer wall 40A of a continuous film, and one inner wall 9 is surrounded by the frame-shaped outer wall 40B. In the outer wall 40A of the continuous film, an outer wall 40Aa with respect to one inner wall 9 and an outer wall 40Ab with respect to the other inner wall 9 are connected to each other. Thus, the outer wall 40A is configured as one film pattern including the plurality of outer walls 40Aa and 40Ab.

In FIGS. 14(a) and 14(b), the configuration in which the inner walls 9 arranged in a row are surrounded by the outer wall 40 is exemplified. As illustrated in FIGS. 15(a), 15(b), and 15(c), the inner walls 9 arranged in a plurality of rows may be surrounded by the outer wall 40. Although the number of the inner walls 9 per row and the number of rows are not limited, here, two rows in which three inner walls 9 are aligned in a row are provided. In the example illustrated in FIG. 15(a), a plurality of rows of inner walls 9 are collectively surrounded by one outer wall 40.

In the example illustrated in FIG. 15(b), an outer wall 40C of a continuous film surrounds the inner walls 9 of one row, and an outer wall 40D of a continuous film surrounds the inner walls 9 of the other row. The outer wall 40C is configured as a pattern of a continuous film including a plurality of outer walls 40Ca, 40Cb, and 40Cc. The outer wall 40D is configured as a pattern of a continuous film including a plurality of outer walls 40Da, 40Db, and 40Dc. In the example illustrated in FIG. 15(c), two rows of inner walls 9 are surrounded by an outer wall 40E of a continuous film. The outer wall 40E is configured as a pattern of a continuous film including a plurality of outer walls 40Ea, 4Eb, 40Ec, 40Ed, 40Ee, and 40Ef.

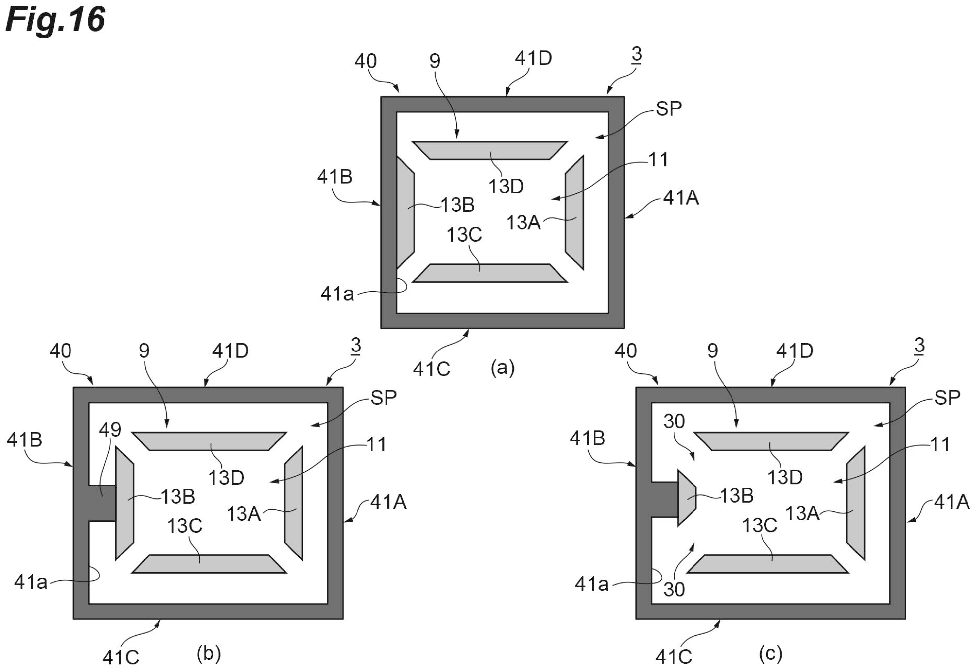

In the above-described embodiment and modification, the outer wall 40 is not in contact with the inner wall 9. However, the outer wall 40 may partially contact the inner wall 9 as long as the effect of the present disclosure can be obtained. In this case, the outer wall 40 can support the inner wall 9 that is subjected to pressure. For example, the structures illustrated in FIGS. 16(a), 16(b), and 16(c) and FIGS. 17(a), 17(b), 17(c), and (17d) may be adopted. FIGS. 16(a), 16(b), and 16(c) and FIGS. 17(a), 17(b), 17(c), and 17(d) illustrate a configuration in which one inner wall 9 is surrounded by one outer wall 40, but these structures may be adopted in the structures of FIGS. 14(a) and 14(b), FIGS. 15(a), 15(b), and 15(c), and the like.

At least one of the four wall-frame portions 41 of the outer wall 40 may come into contact with and support the wall-frame portion 13 of the inner wall 9. In the example illustrated in FIG. 16(a), the wall-frame portion 41B supports the wall-frame portion 13B. In this configuration, the space SP is not formed between the wall-frame portion 41B and the wall-frame portion 13B. In this state, the outer wall 40 surrounds the cavity 11 while being partially in contact with the inner wall 9. In this case, the contamination range of the base material 8 by the constituent material 20 can be narrowed outside the wall-frame portion 13B. In the example illustrated in FIG. 16(b), the wall-frame portion 41B is in contact with the wall-frame portion 13B via a spacer 49. In this configuration, the space SP is formed between the wall-frame portion 41B and the wall-frame portion 13B. In the example illustrated in FIG. 16(c), the width of the wall-frame portion 13B supported by the spacer 49 is reduced in accordance with the shape of the spacer 49. Therefore, the width of the groove portions 30 on both sides of the wall-frame portion 13B is increased.

As illustrated in FIGS. 17(a), 17(b), 17(c), and 17(d), a plurality of wall-frame portions 41 among the four wall-frame portions 41 may come into contact with the wall-frame portions 13 of the inner wall 9. In the example illustrated in FIG. 17(a), the wall-frame portions 41A and 41B support the wall-frame portions 13Aand 13B. In this configuration, the space SP is formed at two locations between the wall-frame portions 41C and 41D and the wall-frame portions 13C and 13D. In this state, the outer wall 40 surrounds the cavity 11 while being in contact with the inner wall 9 in two directions. In the example illustrated in FIG. 17(b), the wall-frame portions 41A, 41B, and 41C in three directions support the wall-frame portions 13A, 13B, and 13C. In this configuration, the space SP is formed at one location between the wall-frame portion 41D and the wall-frame portion 13D. In this state, the outer wall 40 surrounds the cavity 11 while being in contact with the inner wall 9 in three directions. In the example illustrated in FIG. 17(c), the wall-frame portions 41A, 41B, 41C, and 41D in four directions are in contact with the wall-frame portions 13A, 13B, 13C, and 13D via the spacers 49. In this configuration, the space SP is formed between the wall-frame portions 41 in four directions and the wall-frame portions 13. In the example illustrated in FIG. 17d(c), the width of the wall-frame portions 13A, 13B, 13C, and 13D supported by the spacers 49 is reduced in accordance with the shape of the spacers 49.

### [Examples]

Examples of the mounting board according to the present disclosure will be described. Note that the present disclosure is not limited to the following Examples.

First, mounting boards of Examples 1 to 7 were prepared by the following manufacturing method. First, the circuit board 3 was obtained by forming the inner wall 9 having the groove portion 30 and the outer wall 40 on the base material 8 so as to surround the terminals 10 and the bonding material 4. Next, the circuit board 3 was filled with the constituent material 20, and an LED chip was installed as the electronic component 2. Next, the mounting board 1 in this state was pressurized at 0.01 MPa by the pressurization reflow device 49 and reflowed at 150°C to 190°C. As a result, the circuit board 3 and the electronic component 2 were bonded. Various conditions of Examples 1 to 7 are shown in Tables 1 and 2 below. The "inner wall (inner) opening width W1" in Table 1 is a dimension in the longitudinal direction of the reference shape T1 on the inner peripheral side of the inner wall 9 (see FIG. 3). The "inner wall (inner) opening width L1" is a dimension in the lateral direction of the reference shape T1 on the inner peripheral side of the inner wall 9 (see FIG. 3). The "inner wall frame width bottom" is a thickness Ti at the position of the base material 8 of the wall-frame portion 13 of the inner wall 9 (see FIG. 2). The "inner wall (outer) opening width W2" is a dimension in the longitudinal direction of the reference shape T2 on the outer peripheral side of the inner wall 9 (see FIG. 3). The "inner wall (outer) opening width L2" is a dimension in the lateral direction of the reference shape T2 on the outer peripheral side of the inner wall 9 (See FIG. 3). The "inner wall height" is the height Hi of the inner wall 9 (see FIG. 2). The "groove portion opening position" indicates the position of the groove portion 30. "Up, down, left, and right" means that the groove portion 30 is provided at a central position of each of the wall-frame portions 13A, 13B, 13C, and 13D, and "four corners" means that the groove portion 30 is provided at the corner positions where the wall-frame portions 13A, 13B, 13C, and 13D intersect each other. The "groove portion opening Top width" is a dimension of the width of the groove portion 30 at the distal end portion 13c. The "resist opening Bottom" in Table 2 means the bottom width of the groove portion 30. The "margin" indicates a distance between the inner wall 9 and the outer wall 40. The "outer wall (inner) opening width W1" is a dimension in the longitudinal direction of the rectangle drawn by the inner peripheral surface 41a of the outer wall 40 (see FIG. 3). The "outer wall (inner) opening width L1" is a dimension in the lateral direction of the rectangle drawn by the inner peripheral surface 41a of the outer wall 40 (see FIG. 3). The "outer wall frame width bottom" is the thickness To at the position of the base material 8 of the wall-frame portion 41 of the outer wall 40 (see FIG. 2). Note that Examples (other than Example 7) in which dimensions are described have the configuration of FIG. 11. Examples 3 and 6 described as "solid film" have the configuration of FIG. 12 having a continuous film. The "outer wall height" is the height Ho of the outer wall 40 (see FIG. 2). The "inner-wall outer-wall bonding" indicates whether or not there is a portion where the outer wall 40 is bonded to the inner wall 9. Example 7 has the configuration illustrated in FIG. 17(a)

**[Table 1]**

| Examples | Inner wall (inner) opening width W1 | Inner wall (inner) opening width L1 | Inner wall frame width bottom | Inner wall (outer) opening width W2 | Inner wall (outer) opening width L2 | Inner wall height | Groove portion opening position | Groove portion opening Top width |
|---|---|---|---|---|---|---|---|---|
| | µm | µm | µm | µm | µm | µm | - | µm |
| Example 1 | 29 | 19 | 7 | 43 | 33 | 7.5 | Up, down, left, and right | 5 |
| Example 2 | 29 | 19 | 7 | 43 | 33 | 7.5 | Up, down, left, and right | 5 |
| Example 3 | 29 | 19 | 7 | 43 | 33 | 7.5 | Up, down, left, and right | 5 |
| Example 4 | 19 | 12 | 7 | 33 | 26 | 7.5 | Four corners | 5 |
| Example 5 | 19 | 12 | 7 | 33 | 26 | 7.5 | Four corners | 5 |
| Example 6 | 19 | 12 | 7 | 33 | 26 | 7.5 | Four corners | 5 |
| Example 7 | 19 | 12 | 7 | 33 | 26 | 7.5 | Four corners | 5 |

**[Table 2]**

| Examples | Resist opening Bottom | Margin | Outer wall (inner) opening width W1 | Outer wall (inner) opening width L1 | Outer wall frame width bottom | Outer wall height | Inner-wall outer-wall bonding |
|---|---|---|---|---|---|---|---|
| | - | µm | µm | µm | µm | µm | - |
| Example 1 | 2 | 3 | 49 | 39 | 7 | 6.5 | No |
| Example 2 | 2 | 2 | 46 | 36 | 7 | 6.5 | No |
| Example 3 | 2 | 3 | 49 | 39 | - (Solid film) | 6.5 | No |
| Example 4 | 2 | 2 | 37 | 30 | 7 | 6.5 | No |
| Example 5 | 2 | 1 | 35 | 28 | 7 | 6.5 | No |
| Example 6 | 2 | 2 | 37 | 30 | - (Solid film) | 6.5 | No |
| Example 7 | 2 | 2 | 37 | 30 | 7 | 6.5 | Yes |
| | | | | | | | Two sides in left and right |

Table 3 below shows the evaluation results of Examples 1 to 7. The evaluation shown in Table 3 shows the evaluation results when the number of sample circuit boards 3 corresponding to "the installed number" were prepared and the electronic component 2 was installed on these circuit boards 3. "Outflow of constituent material to outside of outer wall" in Table 3 indicates a result as to whether or not there was a sample in which the constituent material 20 flowed out of the outer wall 40. In all of Examples 1 to 7, there was no outflow. The "electronic component installation NG" indicates a result as to whether or not there is an NG product on which the electronic component 2 could not be installed on the circuit board 3. In all of Examples 1 to 7, there was no NG product. The "electronic component installation rate" indicates the percentage of samples in which the electronic component 2 can be installed on the circuit board 3. In all of Examples 1 to 7, the installation rate was 100%. "OK" indicates the number of samples that are OK for all of the evaluation results. In all of Examples 1 to 7, all 28 samples were OK products. The "inner wall inside volume" shown in Table 3 indicates the volume S1 in the cavity 11. The "chip occupied volume" indicates the volume S3 occupied by the electronic component 2 in the cavity 11. The "volume in inner-outer wall" is the volume S2 of the space SP (see FIG. 3) between the inner wall 9 and the outer wall 40. All of Examples 1 to 7 satisfy the conditions of "S2 ≤ S1" and "S2 ≥ S3".

**[Table 3]**

| Examples | Outflow of constituent material to outside of outer wall | Electronic component installation NG | Electronic component installation rate | Installed number | OK | Inner wall inside volume S1 | Chip occupied volume S3 | Volume in inner-outer wall S2 |
|---|---|---|---|---|---|---|---|---|
| | - | | % | | | µm³ | µm³ | µm³ |
| Example 1 | No | No | 100 | 28 | 28 | 4132.5 | 1500 | 3198 |
| Example 2 | No | No | 100 | 28 | 28 | 4132.5 | 1500 | 1540.5 |
| Example 3 | No | No | 100 | 28 | 28 | 4132.5 | 1500 | 3198 |
| Example 4 | No | No | 100 | 28 | 28 | 1710 | 735 | 1638 |
| Example 5 | No | No | 100 | 28 | 28 | 1710 | 735 | 793 |
| Example 6 | No | No | 100 | 28 | 28 | 1710 | 735 | 1638 |
| Example 7 | No | No | 100 | 28 | 28 | 1710 | 735 | 962 |

### [Aspect 1]

A circuit board including:
a base material having a main surface;
a first terminal and a second terminal provided on the main surface of the base material; and
an inner wall of an insulating material provided on the main surface of the base material, wherein
the first terminal and the second terminal are disposed in a cavity surrounded by the inner wall,
the inner wall includes at least one groove portion penetrating an outer peripheral surface from an inner peripheral surface, and
an outer wall of an insulating material is provided on the main surface of the base material on an outer peripheral side of the inner wall so as to surround the cavity.

### [Aspect 2]

The circuit board according to aspect 1, wherein a height of the inner wall is equal to or higher than a height of the outer wall.

### [Aspect 3]

The circuit board according to aspect 1 or 2, wherein when a volume of a space between the inner wall and the outer wall is defined to be S2, and a volume occupied by an electronic component mounted in the cavity is defined to be S3, S2 is S3 or more.

### [Aspect 4]

The circuit board according to any one of aspects 1 to 3, wherein
a surface of at least one of the inner wall and the outer wall, the surface extending in a first direction orthogonal to the main surface of the base material, has a recessed portion at a position on a side of the base material in the first direction, and
a cavity material covering the substrate is provided at a position of the recessed portion.

### [Aspect 5]

The circuit board according to any one of aspects 1 to 4, wherein an end portion of an inner peripheral surface of the outer wall, the end portion being on a side of the base material in a first direction orthogonal to the main surface of the base material, is disposed on an inner peripheral side of a distal end portion.

### [Aspect 6]

The circuit board according to any one of aspects 1 to 5, wherein
when a thickness of a wall-frame portion of the outer wall at a distal end portion in a first direction orthogonal to the main surface of the base material is defined to be Tto, a thickness of the wall-frame portion of the outer wall at an end portion on a side of the base material is defined to be Tbo, and a height of the wall-frame portion of the outer wall is defined to be Ho,
a condition of a tapered shape in which Tbo is equal to or larger than Tto and equal to or larger than Ho is satisfied.

### [Aspect 7]

The circuit board according to any one 1 of aspects 1 to 6, wherein
a plurality of the inner walls, the plurality being n pieces, are provided in the outer wall, and
following Formulas (1) and (2) are satisfied in which SA1 represents an area in each of the plurality of inner walls and SA2 represents a total area between the plurality of inner walls and the outer wall, when viewed in a first direction orthogonal to the main surface of the base material: $SA 2 \geq \left(n\times SA1\right) / 3$ $SA 2 \leq n \times SA 1$

### [Aspect 8]

The circuit board according to any one of aspects 1 to 7, wherein the outer wall at least partially contacts the inner wall.

### [Aspect 9]

The circuit board according to any one of aspects 1 to 8, wherein
when viewed in a thickness direction of a wall-frame portion of the inner wall, the groove portion extends from a distal end portion of the wall-frame portion in a first direction orthogonal to the main surface of the base material toward a side of the base material, and
a width of the groove portion in a width direction orthogonal to the thickness direction and the first direction is larger on a side of the distal end portion than on a side of bottom surface.

### [Aspect 10]

A method for manufacturing a mounting board, the method including mounting an electronic component on the circuit board according to any one of aspects 1 to 9 to manufacture a mounting board, the method including
disposing a constituent material on the base material, disposing the electronic component, and then bonding the electronic component to a terminal by using a pressurization reflow device.

### Reference Signs List

- 1: Mounting board
- 2: Electronic component
- 3: Circuit board
- 4A: Bonding material
- 8: Base material
- 9: Inner wall
- 10: Terminal (First terminal, Second terminal)
- 11: Cavity
- 20: Constituent material
- 30: Groove portion
- 40: Outer wall
- 41: Wall-frame portion
- 41c: Distal end portion
- 41d: End portion
- 49: Pressurization reflow device

## Claims

1. A circuit board comprising:
a base material having a main surface;
a first terminal and a second terminal provided on the main surface of the base material; and
an inner wall of an insulating material provided on the main surface of the base material, wherein
the first terminal and the second terminal are disposed in a cavity surrounded by the inner wall,
the inner wall includes at least one groove portion penetrating an outer peripheral surface from an inner peripheral surface, and
an outer wall of an insulating material is provided on the main surface of the base material on an outer peripheral side of the inner wall so as to surround the cavity.

2. The circuit board according to claim 1, wherein a height of the inner wall is equal to or higher than a height of the outer wall.

3. The circuit board according to claim 1, wherein when a volume of a space between the inner wall and the outer wall is defined to be S2, and a volume occupied by an electronic component mounted in the cavity is defined to be S3, S2 is S3 or more.

4. The circuit board according to claim 1, wherein
a surface of at least one of the inner wall and the outer wall, the surface extending in a first direction orthogonal to the main surface of the base material, has a recessed portion at a position on a side of the base material in the first direction, and
a cavity material covering the substrate is provided at a position of the recessed portion.

5. The circuit board according to claim 1, wherein an end portion of an inner peripheral surface of the outer wall, the end portion being on a side of the base material in a first direction orthogonal to the main surface of the base material, is disposed on an inner peripheral side of a distal end portion.

6. The circuit board according to claim 1, wherein
when a thickness of a wall-frame portion of the outer wall at a distal end portion in a first direction orthogonal to the main surface of the base material is defined to be Tto, a thickness of the wall-frame portion of the outer wall at an end portion on a side of the base material is defined to be Tbo, and a height of the wall-frame portion of the outer wall is defined to be Ho,
a condition of a tapered shape in which Tbo is equal to or larger than Tto and equal to or larger than Ho is satisfied.

7. The circuit board according to claim 1, wherein
a plurality of the inner walls, the plurality being n pieces, are provided in the outer wall, and
following Formulas (1) and (2) are satisfied in which SA1 represents an area in each of the plurality of inner walls and SA2 represents a total area between the plurality of inner walls and the outer wall, when viewed in a first direction orthogonal to the main surface of the base material: $SA 2 \geq \left(n\times SA1\right) / 3$ $SA 2 \leq n \times SA 1$

8. The circuit board according to claim 1, wherein the outer wall at least partially contacts the inner wall.

9. The circuit board according to claim 1, wherein
when viewed in a thickness direction of a wall-frame portion of the inner wall, the groove portion extends from a distal end portion of the wall-frame portion in a first direction orthogonal to the main surface of the base material toward a side of the base material, and
a width of the groove portion in a width direction orthogonal to the thickness direction and the first direction is larger on a side of the distal end portion than on a side of a bottom surface.

10. A method for manufacturing a mounting board, the method including mounting an electronic component on the circuit board according to any one of claims 1 to 9 to manufacture a mounting board, the method comprising
disposing a constituent material on the base material, disposing the electronic component, and then bonding the electronic component to a terminal by using a pressurization reflow device.
